# EUROPÄISCHE PATENTSCHRIFT

(11) **EP 1 805 958 B1**
(45) Veröffentlichungstag und Bekanntmachung des Hinweises auf die Patenterteilung: **19.12.2007**
(21) Anmeldenummer: 05798050.0
(22) Anmeldetag: 17.10.2005
(51) Int. Cl.: H04L 27/20

(54) **ANORDNUNG ZUR SYNCHRONEN AUSGABE VON IN ZWEI ODER MEHR DIGITALE/ANALOG-WANDLERN ERZEUGTEN ANALOGSIGNALEN**
ARRANGEMENT FOR THE SYNCHRONOUS EMISSION OF ANALOG SIGNALS PRODUCED IN AT LEAST TWO DIGITAL/ANALOG CONVERTERS
DISPOSITIF D'EMISSION SYNCHRONE DE SIGNAUX ANALOGIQUES PRODUITS DANS AU MOINS DEUX CONVERTISSEURS NUMERIQUE/ANALOGIQUE

(30) Priorität: 18.10.2004 DE 102004050648
(43) Veröffentlichungstag der Anmeldung: 11.07.2007
(73) Patentinhaber: Rohde & Schwarz GmbH & Co. KG, 81671 München (DE)
(72) Erfinder: KUFER, Wolfgang, 84453 Mühldorf (DE)
(74) Vertreter: Körfer, Thomas
(86) Internationale Anmeldenummer: PCT/EP2005/011153
(87) Internationale Veröffentlichungsnummer: WO 2006/042731

(56) Entgegenhaltungen:
- DE-A1- 1 762 655
- US-A- 5 930 299
- US-A1- 2003 112 894

## Beschreibung

Die Erfindung betrifft eine Anordnung zur synchronen Ausgabe von in zwei oder mehr Digital/Analog (D/A)-Wandlern erzeugten Analogsignalen laut Oberbegriff des Hauptanspruches.

Bei der üblichen Digital/Analog-Wandlung werden in der Regel zwei zueinander synchrone Takte verwendet. Ein Takt steuert dabei den Digitalteil, ein anderer Takt mit besonderen Anforderungen an die Taktreinheit den eigentlichen Wandler. Die Übergabe der Signale zwischen diesen Takten erfolgt im allgemeinen synchron, das heißt mit bekannter Verzögerung. Bei hohen Taktraten wird das Einhalten der entsprechenden Set up- und Hold-Zeiten an der Übergabe-Schnittstelle zunehmend schwieriger, so dass für die Übergabe der Signale ein Fifo-Speicher (first in first out-Speicher) dem eigentlichen Wandler vorgeschaltet wird. Dieser Fifo-Speicher ist meist in den Wandler integriert. Damit ist zwar eine Synchronisation mit konstanter Verzögerung des Signals möglich, je nach Initialisierung des Fifo-Speichers kann die Verzögerung jedoch unterschiedliche Werte annehmen. Die Zwischenschaltung eines Fifo-Speichers löst daher dieses Problem bei hohen Taktraten noch nicht vollständig.

Ein besonderes Problem besteht, wenn derart erzeugte Analogsignale synchron zueinander oder synchron zu einem Markersignal erzeugt werden sollen, das zwar zusammen mit dem die Analogsignale erzeugenden Digitalsignal erzeugt wird jedoch nicht über die Digital/Analog-Wandler ausgegeben wird. In diesem Fall ist die unsichere Phasenlage der Analogsignale zu dem Markersignal kritisch.

US2003/0112894 zeigt die Einführung von zwei Verzögerungsgliedern vor den zwei Digital/Analog-Wandlern eines PSK-Modulators. Die Verzögerungsglieder verzögern die Eingangsdaten der D/A-Wandler abhängig vom Phasenunterschied der Ausgangssignale.

Es ist daher Aufgabe der Erfindung, eine Anordnung und ein Verfahren zu schaffen, die eine exakte Synchronisation der in zwei oder mehr Digital/Analog-Wandlern erzeugten Analogsignalen ermöglicht.

Diese Aufgabe wird bezüglich der Anordnung durch die Merkmale des Anspruchs 1 und bezüglich des Verfahrens durch die Merkmale des Anspruchs 7 gelöst. Vorteilhafte Weiterbildungen insbesondere auch bezüglich der Synchronisation mit einem Markersignal ergeben sich aus den Unteransprüchen.

Bei der erfindungsgemäßen Anordnung kann über die einstellbare digitale Zeitverzögerungseinrichtung eine exakte Synchronisation der über die D/A-Wandler ausgegebenen Analogsignale eingestellt werden. Im einfachsten Fall mit nur zwei D/A-Wandlern, wie dies beispielsweise bei der Erzeugung von analogen I- und Q-Signalen aus einem vorgegebenen I/Q-Digitalsignaldatenstrom der Fall ist, ist es ausreichend, nur dem einen D/A-Wandler eine einstellbare digitale Verzögerungseinrichtung zuzuordnen. Zweckmäßigerweise werden jedoch jedem D/A-Wandler entsprechende einstellbare digitale Verzögerungseinrichtungen zugeordnet, vor allem dann, wenn eine Synchronisation der Analogsignale mit einem zusätzlichen Markersignal erforderlich ist.

Die abgleichbare digitale Verzögerungseinrichtung vor den D/A-Wandlern besteht vorzugsweise jeweils aus einer Verzögerungsschaltung, deren Verzögerung auf ganze Taktperioden einstellbar ist, sowie einem in Kaskade damit angeordneten Interpolationsfilter, dessen Verzögerung auf Bruchteile von Taktperioden einstellbar ist. Solche Verzögerungsschaltungen sind beispielsweise als sogenannte Delay-Pipeline beziehungsweise als Filter bekannt und gängige Bausteine der Elektronik. Für die Verzögerung des Markersignals wird eine Verzögerungsschaltung eingesetzt, deren Verzögerung nur auf ganzzahlige Taktperioden einstellbar ist. Das einstellbare Filter, mit denen auch Bruchteile des Taktes einstellbar sind, werden beispielsweise von der Firma Logic Devices unter der Handelsbezeichnung LT 4420 oder LF 3320 vertrieben, auch die einstellbaren Delay-Pipelines sind handelsüblich.

Die erfindungsgemäße Anordnung ist zwar vor allem für die Synchronisation von zwei D/A-Wandlern von Vorteil, wie sie bei der Erzeugung von I/Q-Analogsignalen benutzt werden, sie ist jedoch auch in anderen Anwendungsfällen von Vorteil, bei denen die analogen Ausgangssignale von drei oder mehr D/A-Wandlern synchronisiert werden sollen.

Die Erfindung wird im folgenden anhand schematischer Zeichnungen an zwei Ausführungsbeispielen näher erläutert.
- Fig. 1: zeigt das Prinzipschaltbild einer erfindungsgemäßen Anordnung zur Synchronisation von zwei D/A-Wandlern ohne Markersignal;
- Fig. 2: zeigt die gleichen Anordnung für die Synchronisation von zwei Analogsignalen mit einem zusätzlichen Markersignal.

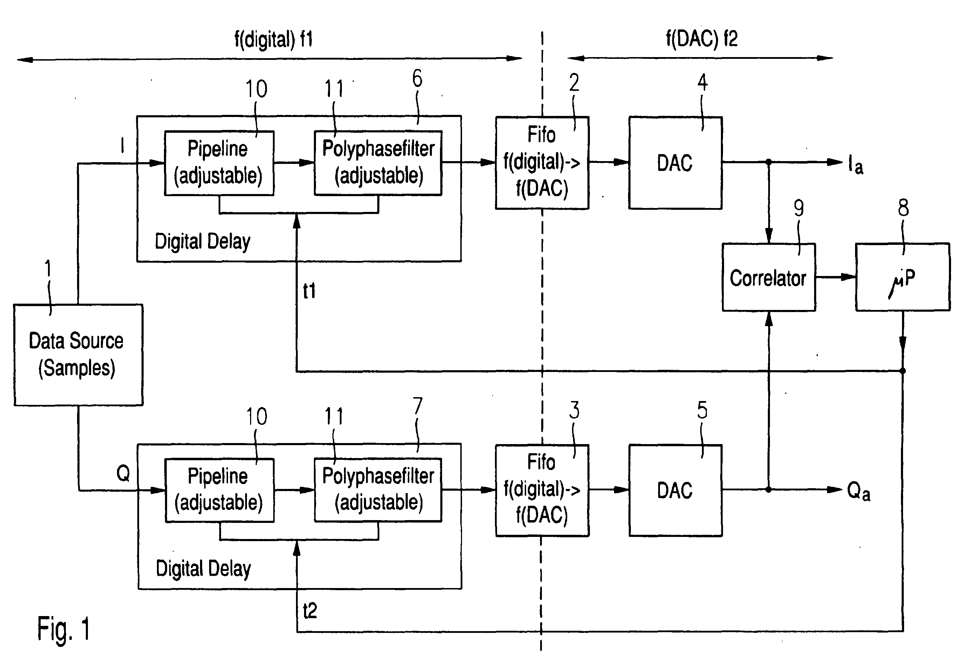

Im Ausführungsbeispiel nach Fig. 1 werden aus einer Datenquelle 1 die beiden digitalen Datensignale I und Q mit einem Takt fl jeweils über Fifo-Speicher 2 und 3 den D/A-Wandlern 4 und 5 zugeführt. Der Fifo-Speicher 2 und 3 sind meist schon in die D/A-Wandler integriert. Die Digital/Analog-Wandler 4 und 5 arbeiten mit einem besonders reinen Systemtakt f2. Im Beispiel ist vor jedem der Fifo-Speicher 2 und 3 jeweils eine einstellbare digitale Verzögerungseinrichtung 6 beziehungsweise 7 angeordnet, deren Verzögerungszeiten t1 beziehungsweise t2 über einen Mikroprozessor 8 in Abhängigkeit von einem Korrelator 9 einstellbar sind. Jede der beiden digitalen Verzögerungseinrichtungen 6 und 7 besteht vorzugsweise jeweils aus einer Verzögerungsschaltung 10, deren Verzögerungszeit jeweils auf volle Taktperioden einstellbar ist, beispielsweise einer sogenannten Delay-Pipeline, sowie einem in Kaskade damit angeordneten Interpolationsfilter 11, dessen Verzögerungszeit auf Bruchteile einer Taktperiode einstellbar ist.

Die analogen Ausgangssignale Iₐ beziehungsweise Qₐ der beiden D/A-Wandler 4 und 5 werden im Korrelator 9 einer Kreuzkorrelation unterworfen. Durch relatives Verschieben der beiden Analogsignale zueinander und Messen der Korrelationsfunktion ergibt sich eine Korrelationskennlinie, deren Maximum die Verzögerungszeiten t1 beziehungsweise t2 der beiden digitalen Verzögerungseinrichtungen 6 und 7 bestimmt.

Diese mathematische Kreuzkorrelation zweier Funktionen und Bestimmung des Maximums der Korrelationskennlinie erfolgt in bekannter Weise im Korrelator 9, das Ergebnis der Maximum-Bestimmung wird im Rechner 8 zur Einstellung der Verzögerungszeiten t1 und t2 umgesetzt. Für diese Einstellung der Verzögerungszeiten in Abhängigkeit von der Kreuzkorrelation wird der Anordnung am Eingang vorzugsweise ein entsprechendes digitales Synchronisationsmuster zugeführt, das ein für die Korrelation besonders günstiges Ausgangssignal liefert, beispielsweise einen sogenannten Gauß'schen Puls.

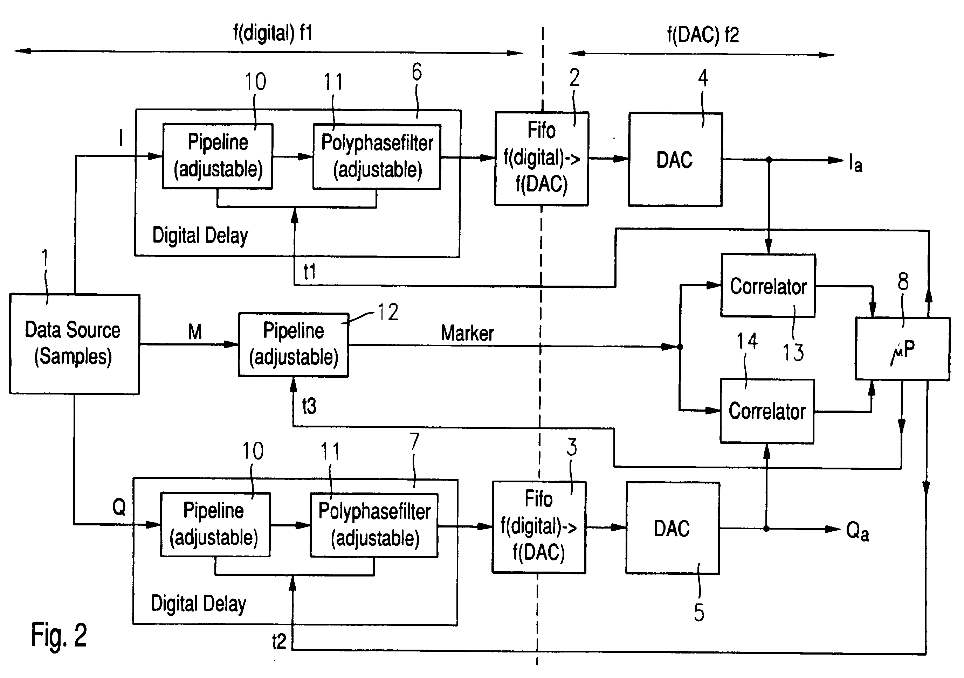

Fig. 2 zeigt eine Anordnung, bei der zusätzlich zu den Digitalsignalen I und Q aus der Datenquelle 1 ein zusammen mit den Digitalsignalen erzeugtes Markersignal M direkt zum Ausgang ausgegeben wird. Die übrigen Bestandteile der Anordnung entsprechen denen der Fig. 1 und sind daher mit gleichen Bezugszeichen bezeichnet. Das Markersignal M wird ebenfalls über eine einstellbare digitale Verzögerungseinrichtung 12 zeitlich verzögert und zwei Korrelatoren 13 und 14 zugeführt, die ihrerseits wieder über einen Rechner 8 die Einstellung der in diesem Fall drei Verzögerungszeiten t1, t2, t3 bewirkt. Im Korrelator 13 wird das Ausgangssignal Iₐ mit dem Markersignal M und im Korrelator 14 das Markersignal M mit dem Ausgangssignal Qₐ korreliert. In diesem Beispiel dient also das Markersignal als Bezugssignal, auf das die beiden Ausgangssignale Iₐ und Qₐ synchronisiert werden.

Der Abgleich der digitalen Verzögerungseinrichtungen gemäß Fig. 2 erfolgt folgendermaßen:

Zunächst werden nach dem Einschalten des Systems die beiden digitalen Verzögerungseinrichtungen 6 und 7 auf Null gesetzt (t1 = 0, t2 = 0).

Dann wird aus der Datenquelle 1 sowohl auf die Signalpfade I und Q als auch auf den Markerkanal ein für die Synchronisation geeignetes digitales Synchronisationsmuster gegeben, auf den Markerkanal beispielsweise die Datenfolge 00011000 und auf die Signalpfade ein Digitalsignal, das am Ausgang der D/A-Wandler einen Gauß'schen Puls erzeugt. Mit diesem Synchronisationsmuster wird dann die Verzögerungszeit t3 der digitalen Verzögerungseinrichtung 12 in ganzen Taktperioden verändert und es wird gleichzeitig über die Korrelatoren 13 und 14 jeweils die Korrelationsfunktion zwischen Markersignal und analogen Ausgangssignalen gemessen.

Es ergibt sich dann in bekannter Weise eine Korrelationskennlinie über der Verzögerungszeit t3. Durch Interpolieren des Maximums dieser Kennlinie wird in den Korrelatoren 13 und 14 jeweils die optimale Verzögerungszeit t1 beziehungsweise t2 ermittelt. An der Stelle des Maximums liegt die tatsächliche Laufzeit der Analogsignale. Über den Rechner 8 wird der Zeitwert t1 beziehungsweise t2 in den digitalen Verzögerungseinrichtungen eingestellt. Damit erfolgt dann die Ausgabe der Analogsignale Iₐ und Qₐ exakt synchron zueinander und zum Markersignal.

Der Korrelator kann auch nicht direkt hinter den D/A-Wandlern angeordnet sein, sondern es kann auch eine beliebige Signalübertragungsstrecke zwischen Ausgabeteil und Korrelator liegen. Auf diese Weise lassen sich eventuell unbekannte Signalübertragungszeiten aneinander angleichen.

## Patentansprüche

1. Anordnung zur synchronen Ausgabe von in zumindest zwei Digital/Analog-Wandlern (4, 5) erzeugten Analogsignalen (Iₐ Qₐ), bei der die Digitalsignale (I, Q) mit einer ersten Taktfrequenz (f₁) erzeugt und in den Digital/Analog-Wandlern (4, 5) mit einer zweiten Taktfrequenz (f₂) in Analogsignale gewandelt werden und die Signalübergabe zu den Digital/Analog-Wandlern (4, 5) über Fifo-Speicher (2, 3) verzögert erfolgt,
**dadurch gekennzeichnet,**
**dass** vor dem Fifo-Speicher (2, 3) vor mindesten einem der Digital/Analog-Wandler (4, 5) eine einstellbare digitale Verzögerungseinrichtung (6; 7) zum Verzögern der Digitalsignale vorgesehen ist, deren Verzögerungszeit (t1; t2) in Abhängigkeit von der zwischen den analogen Ausgangssignalen (Iₐ Qₐ) der Digital/Analog-Wandler (4, 5) bestimmten Kreuzkorrelation einstellbar ist.

2. Anordnung nach Anspruch 1,
**dadurch gekennzeichnet,**
**dass** vor jedem Fifo-Speicher (2, 3) jedes der Digital/Analog-Wandler (4, 5) eine einstellbare digitale Verzögerungseinrichtung (6, 7) angeordnet ist.

3. Anordnung nach Anspruch 1 oder 2,
**dadurch gekennzeichnet,**
**dass** die einstellbare digitale Verzögerungseinrichtung (6, 7) jeweils aus einer einstellbaren digitalen Verzögerungsschaltung (10), deren Verzögerungszeit jeweils um ganze Taktperioden einstellbar ist, und einem in Kaskade damit angeordneten digitalen Interpolationsfilter (11), dessen Verzögerungszeit auf Bruchteile einer Taktperiode einstellbar ist, besteht.

4. Anordnung nach einem der vorhergehenden Ansprüche,
**dadurch gekennzeichnet,**
**dass** gleichzeitig ein zusammen mit den Digitalsignalen erzeugtes Markersignal (M) direkt zum Ausgang übertragen wird und
**dass** das Markersignal (M) über eine einstellbare digitale Verzögerungseinrichtung (12) direkt zum Ausgang übertragen wird, und die Verzögerungszeit (t3) des Markersignals sowie die Verzögerungszeiten (t1, t2) der den Digital/Analog-Wandlern (4, 5) zugeführten Digitalsignale in Abhängigkeit von der Kreuzkorrelation eingestellt wird, die zwischen den analogen Ausgangssignalen (Iₐ, Qₐ) der Digital/Analog-Wandler (4, 5) und dem verzögerten Markersignal bestimmt wird.

5. Anordnung nach Anspruch 4,
**dadurch gekennzeichnet,**
**dass** die dem Markersignal (M) zugeordnete einstellbare digitale Verzögerungseinrichtung (12) eine auf ganzzahlige Taktperioden einstellbare Verzögerungsschaltung (10) ist.

6. Anordnung nach einem der vorhergehenden Ansprüche,
**dadurch gekennzeichnet,**
**dass** die einstellbaren digitalen Verzögerungseinrichtungen (6, 7, 12) jeweils mit der ersten Taktfrequenz (f1) gesteuert sind.

7. Verfahren zum Einstellen einer Anordnung nach Anspruch 4 zur synchronen Ausgabe von in zumindest zwei Digital/Analog-Wandlern (4, 5) erzeugten Analogsignalen mit zugehörigen Markersignalen,
**dadurch gekennzeichnet,**
**dass** zunächst die den Digital/Analog-Wandlern (4, 5) zugeordneten digitalen Verzögerungseinrichtungen (6, 7) auf eine Verzögerungszeit Null eingestellt werden,
**dass** dann als Digitalsignal mit zugeordnetem Markersignal (M) ein Synchronisationsmuster zugeführt wird,
**dass** die Verzögerung des Markersignals (M) mittels der diesem zugeordneten einstellbaren digitalen Verzögerungseinrichtung verändert wird und gleichzeitig die Kreuzkorrelationsfunktion zwischen den Analogsignalen der Digital/Analog-Wandler (4, 5) und dem Markersignal (M) gemessen wird,
**dass** das Maximum der so über der Verzögerungszeit des Markersignals (M) gewonnenen Korrelationskennlinie bestimmt wird und
**dass** schließlich die den Digital/Analog-Wandlern (4, 5) zugeordneten einstellbaren digitalen Verzögerungseinrichtungen (6, 7) auf den diesem Maximum entsprechenden zeitwert eingestellt werden.

## Claims

1. Arrangement for the synchronous output of analog signals (Iₐ, Qₐ) generated in at least two D/A converters (4, 5), wherein the digital signals (I, Q) are generated with a first clock-pulse frequency (f₁) and converted into analog signals in the D/A converters (4, 5) with a second clock-pulse frequency (f₂), and wherein the signal transfer to the D/A converters (4, 5) is implemented in a delayed manner via fifo memories (2, 3),
**characterised in that**
an adjustable digital-delay device (6; 7) for delaying the digital signals, of which the delay time (t1;t2) is adjustable dependent upon the cross-correlation determined between the analog output signals (Iₐ, Qₐ) of the D/A converters (4, 5), is provided upstream of the fifo memory (2, 3) and upstream of at least one of the D/A converters (4, 5).

2. Arrangement according to claim 1,
**characterised in that**
an adjustable digital-delay device (6, 7) is disposed upstream of each fifo memory (2, 3) of each of the D/A converters (4, 5).

3. Arrangement according to claim 1 or 2,
**characterised in that**
each adjustable digital-delay device (6, 7) consists of an adjustable digital-delay circuit (10), of which the respective delay time is adjustable by whole clock-pulse periods, and a digital interpolation filter (11) arranged in cascade with the latter, of which the delay time is adjustable to fractions of a clock-pulse period.

4. Arrangement according to any one of the preceding claims,
**characterised in that**
a marker signal (M) generated together with the digital signals is transmitted at the same time directly to the output, and that
the marker signal (M) is transmitted directly to the output via an adjustable digital-delay device (12), and the delay time (t3) of the marker signal and the delay times (t1, t2) of the digital signals supplied to the D/A converters (4, 5) are adjusted dependent upon the cross correlation, which is determined between the analog output signals (Iₐ, Qₐ) of the D/A converters (4, 5) and the delayed marker signal.

5. Arrangement according to claim 4,
**characterised in that**
the adjustable digital-delay device (12) assigned to the marker signal (M) is a delay circuit (10) adjustable to integer clock-pulse periods.

6. Arrangement according to any one of the preceding
claims,
**characterised in that**
the adjustable digital-delay devices (6, 7, 12) are each controlled at the first clock-pulse frequency (f₁).

7. Method for adjusting an arrangement according to claim 4 for the synchronous output of analog signals generated in at least two D/A converters (4, 5) with associated marker signals,
**characterised in that,**
initially, the digital-delay devices (6, 7) assigned to the D/A converters (4, 5) are adjusted to a delay time of zero, that
a synchronisation pattern is then supplied as a digital signal with assigned marker signal (M), that the delay of the marker signal (M) is varied by means of the adjustable digital-delay device assigned to the latter, and at the same time, the cross-correlation function between the analog signals of the D/A converter (4, 5) and the marker signal (M) is measured, that
the maximum of the correlation characteristic obtained in this manner via the delay time of the marker signal (M) is determined, and that
the adjustable digital-delay devices (6, 7) assigned to the D/A converters (4, 5) are finally adjusted to the time value corresponding to this maximum.

## Revendications

1. Dispositif d'émission synchrone de signaux analogiques (Iₐ, Qₐ) générés dans au moins deux convertisseurs numériques analogiques (4, 5), dans lequel les signaux numériques (I, Q) sont générés avec une première fréquence d'horloge (f1) et convertis dans les convertisseurs numériques analogiques (4, 5) avec une deuxième fréquence d'horloge (f2) en des signaux analogiques et les signaux sont transférés avec un retard aux convertisseurs numériques analogiques (4, 5) par le biais des mémoires FIFO (2, 3),
**caractérisé en ce que**
en amont de chaque mémoire FIFO (2, 3) avant au moins un des convertisseurs numériques analogiques (4, 5), il est prévu un dispositif de retard numérique réglable (6; 7) pour retarder les signaux numériques dont le temps de retard (t1; t2) est réglable en fonction de la corrélation croisée déterminée entre les signaux de sortie analogiques (Iₐ, Qₐ) des convertisseurs numériques analogiques (4, 5).

2. Dispositif selon la revendication 1, **caractérisé en ce qu'**un dispositif de retard numérique réglable (6, 7) est disposé en amont de chaque mémoire FIFO (2, 3) de chacun des convertisseurs numériques analogiques (4, 5).

3. Dispositif selon la revendication 1 ou 2, **caractérisé en ce que** chaque dispositif de retard numérique réglable (6, 7) se compose d'un circuit de retard numérique réglable (10), dont le temps de retard est réglable par périodes d'horloge entières, et d'un filtre d'interpolation (11), placé en cascade avec le circuit de retard, dont le temps de retard est réglable sur des fractions d'une période d'horloge.

4. Dispositif selon une des revendications précédentes, **caractérisé**
**en ce que**, en même temps, un signal de balise (M) généré conjointement aux signaux numériques est transmis directement à la sortie et
**en ce que** le signal de balise (M) est transmis directement à la sortie par le biais d'un dispositif de retard numérique réglable (12), et le temps de retard (t3) du signal de balise ainsi que les temps de retard (t1, t2) des signaux numériques amenés aux convertisseurs numériques analogiques (4, 5) sont réglés en fonction de la corrélation croisée qui est déterminée entre les signaux de sortie analogiques (Iₐ, Qₐ) des convertisseurs numériques analogiques (4, 5) et le signal de balise retardé.

5. Dispositif selon la revendication 4,
**caractérisé en ce que** le dispositif de retard numérique réglable (12) associé au signal de balise (M) est un circuit de retard (10) réglable sur des nombres entiers de périodes d'horloge.

6. Dispositif selon une des revendications précédentes,
**caractérisé en ce que** les dispositifs de retard numériques réglables (6, 7, 12) sont chacun commandés avec la première fréquence d'horloge (f1).

7. Procédé pour régler un dispositif selon la revendication 4 destiné à une émission synchrone de signaux analogiques générés dans au moins deux convertisseurs numériques analogiques (4, 5) avec des signaux de balise associés,
**caractérisé**
**en ce que**, d'abord, les dispositifs de retard numériques (6, 7) associés aux convertisseurs numériques analogiques (4, 5) sont réglés sur un temps de retard nul,
**en ce que**, ensuite, un motif de synchronisation est amené sous forme de signal numérique avec le signal de balise associé (M),
**en ce que** le retard du signal de balise (M) est modifié au moyen du dispositif de retard numérique réglable associé à celui-ci et en même temps la fonction de corrélation croisée entre les signaux analogiques des convertisseurs numériques analogiques (4, 5) et le signal de balise (M) est mesurée,
**en ce que** le maximum de la caractéristique de corrélation acquise sur le temps de retard du signal de balise (M) est déterminé et
**en ce que**, finalement, les dispositifs de retard numériques réglables (6, 7) associés aux convertisseurs numériques analogiques (4, 5) sont réglés sur la valeur de temps correspondant à ce maximum.
